(19) Europäisches Patentamt
European Patent Office
Office européen des brevets

(11) **EP 2 790 321 A1**

(12) **EUROPEAN PATENT APPLICATION**

(43) Date of publication:
**15.10.2014 Bulletin 2014/42**

(51) Int Cl.:
***H03F 1/26*** (2006.01)      ***H04B 1/04*** (2006.01)

(21) Application number: **13305460.1**

(22) Date of filing: **09.04.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ALCATEL LUCENT**
**92100 Boulogne-Billancourt (FR)**

(72) Inventors:
• **Yu, Xin**
**70435 Stuttgart (DE)**
• **Wong, James**
**Swindon, Wiltshire SN5 7YT (GB)**

(74) Representative: **Hofmann, Dirk**
**Alcatel-Lucent Deutschland AG**
**Intellectual Property Business Group**
**Lorenzstrasse 10**
**70435 Stuttgart (DE)**

(54) **Method for signal amplification in an amplifier apparatus, computer program product, digital data storage device, amplifier apparatus, transmitter apparatus, network node and vehicle thereof**

(57) The embodiments of the invention relate to a method for signal amplification in an amplifier apparatus (AP1). The method contains the steps of generating a difference signal (DS) from an input signal (INS) of the amplifier apparatus (AP1) and a feedback signal (FBS) of the amplifier apparatus (AP1), leveling the difference signal (DS) by a digital signal processing of the difference signal (DS), and amplifying a sum signal (SS) of the input signal (INS) and of the leveled difference signal (DS) by a power amplifier (PA) for generating an amplified output signal (OUTS) of the amplifier apparatus (AP1). The embodiments of the invention further relate to a computer program product, which contains computer-executable instructions for performing the method, to a digital data storage device, which encodes a machine-executable program of instructions to perform the method, to the amplifier apparatus (AP1), to a transmitter apparatus, which contains the amplifier apparatus (AP1) and to a network node, which contains the transmitter apparatus.

*FIG. 1*

Printed by Jouve, 75001 PARIS (FR)

**Description**

**FIELD OF THE INVENTION**

Embodiments of the invention relate to power amplifier technology and, more particularly but not exclusively, to signal noise suppression in power amplifiers for radio frequency signals.

**BACKGROUND**

The increasing use of smart phones and other wireless devices with advanced computing capability in wireless communication systems and their capabilities to download and play videos or television programs even in HD quality (HD = high definition) provides a demand for increasing network capacity of the wireless communication systems. In principle, the network capacity can be increased by using additional bandwidth of the radio spectrum. But operators of the wireless communication systems are limited to those parts of the radio spectrum, which have been licensed by the operators. Licenses for additional bandwidth of the radio spectrum are strongly limited and usually very expensive.
In order to fulfill spectrum emission masks defined by technical specifications such as those from 3GPP (3GPP = 3rd Generation Partnership Project) corresponding radio frequency filters may be applied, which provide tighter rejections for the sidebands. But such radio frequency filters usually exhibit larger insertion losses and require a larger cavity, which results in a weight increase of the radio frequency filter. Thereby, handling of the radio frequency filters is degraded and CAPEX and OPEX for installing a wireless communication system and for operating the wireless communication system increases.
Conventional approaches using power amplifiers for signal noise suppression and noise floor suppression are extremely energy inefficient and therefore also increase the CAPEX of a wireless communication system and don't fit to upcoming so-called Green technologies, which shall reduce an impact of new technologies on carbon footprint and corresponding global warming.

**SUMMARY**

Energy consumption, material consumption and costs are important selection criteria for operators, when selecting products such as macro base stations or femto base stations for advanced radio communication systems. Thus, objects of the embodiments of the invention are reducing energy consumption, material consumption and costs of transmitter apparatuses for radio communication systems.
The object is achieved by a method for signal amplification in an amplifier apparatus. The method contains the steps of generating a difference signal from an input signal of the amplifier apparatus and from a feedback signal of a power amplifier of the amplifier apparatus, leveling the difference signal by a digital signal processing of the difference signal, and amplifying a sum signal of the input signal and of the leveled difference signal by a power amplifier for generating an amplified output signal of the amplifier apparatus.
The object is further achieved by an amplifier apparatus for signal noise suppression. The amplifier apparatus contains means for generating a difference signal from an input signal of the amplifier apparatus and a feedback signal of a power amplifier of the amplifier apparatus, means for leveling the difference signal by a digital signal processing of the difference signal, and means for amplifying a sum signal of the input signal and of the leveled difference signal for generating an amplified output signal of the amplifier apparatus. The amplifier apparatus may be for example an amplifier apparatus for radio frequency signals.
The object is further achieved by a computer program product, which contains computer-executable instructions for performing the above method when the computer program product is executed on a programmable hardware device.
The object is further achieved by a digital data storage device, which encodes a machine-executable program of instructions to perform the above method.
The object is even further achieved by a transmitter apparatus which contains the amplifier apparatus, by a network node which contains the transmitter apparatus and by a vehicle which contains the network node.
In embodiments, the means for generating the difference signal from the input signal of the amplifier apparatus and the feedback signal of the power amplifier of the amplifier apparatus may correspond to any subtraction unit or combinational circuit such as a subtractor, a subtractor circuit, subtraction operation unit etc. Hence, in embodiments, the means for generating the difference signal may contain a first input for the input signal of the amplifier apparatus and a second input for the feedback signal of the power amplifier, an algorithmic unit for performing a subtraction between the input signal of the amplifier apparatus and the feedback signal of the power amplifier for obtaining the difference signal, and an output for the difference signal.
In embodiments, the means for leveling the difference signal may correspond to any leveling unit such as a limiting unit, a limiter, a digital attenuator, etc. Hence, in embodiments the means for leveling the difference signal may contain an input for the difference signal, an algorithmic unit for performing the leveling and for obtaining the leveled difference signal, a memory having storage space for performing the leveling, and an output for the leveled difference signal. In some embodiments the means for leveling the difference signal can be implemented in terms of a computer program and a hardware component on which the computer program is executed, such as a DSP (DSP = Digital Signal Processor), an ASIC (ASIC = Application-Specific Integrated Circuit), an FPGA (FPGA = Field-Programmable Gate Array) or any other processor.

In embodiments, the means for amplifying the sum signal of the input signal and of the leveled difference signal for generating the amplified output signal of the amplifier apparatus may correspond to any amplification unit such as a power amplifier, an amplifier, an RF amplifier (RF = radio frequency) etc, which is designated as the last amplifier in a transmission chain (an output stage) and is an amplifier stage that typically requires most attention to power efficiency. Hence, in embodiments, the means for amplifying the sum signal may contain an input for the sum signal, an amplification unit for performing the amplification and for obtaining the amplified output signal, and an output for the amplified output signal.

The embodiments of the invention provide a first benefit of minimizing a signal noise of the amplified output signal. Up to 20 dB improvement regarding the noise suppression in comparison to conventional amplifier apparatuses may be achieved.

The embodiments of the invention provide a second benefit of not requiring improved radio frequency filters with larger cavity and therefore with higher weight, which may degrade a handing of the radio frequency filters. Thereby, an increase of CAPEX and OPEX for installing a wireless communication system and for operating the wireless communication system can be avoided.

The embodiments of the invention provide a third benefit of allowing a processing and signal conditioning of the difference signal in a baseband without requiring any analogue external error amplifiers. Thereby, the preferred embodiment provides an advantage of being more linear and hence energy efficient with respect to conventional approaches of amplifier apparatuses using error amplifiers.

Preferably, the leveling step of the difference signal by the signal processing contains the sub-steps of converting the difference signal from a first analogue difference signal into a first digital difference signal, leveling the first digital difference signal by the digital signal processing to a second leveled digital difference signal and converting the second leveled digital difference signal into a second analogue difference signal.

In embodiments, means for converting the difference signal from the first analogue difference signal into the first digital difference signal may correspond to any converting unit such as an analogue-to-digital converter, an ADC (ADC = analogue-to-digital converter), an A/D or an A to D etc, which converts a continuous physical quantity (usually voltage) to a digital number that represents the quantity's amplitude. Hence, in embodiments, the means for converting the difference signal from the first analogue difference signal into the first digital difference signal may contain an input for the first analogue difference signal, a converter for performing the conversion of the first analogue difference signal and for obtaining the first digital difference signal, and an output for the first digital difference signal.

In embodiments, means for converting the amplified difference signal from the second digital difference signal into the second analogue difference signal may correspond to any converting unit such as a digital-to-analogue converter, a DAC (DAC = digital-to-analogue converter), a D/A or a D to A etc, which converts a digital (usually binary) code to an analog signal (current, voltage, or electric charge). Hence, in embodiments, the means for converting the amplified difference signal from the second digital difference signal into the second analogue difference signal may contain an input for the second digital difference signal, a converter for performing the conversion of the second digital difference signal and for obtaining the second analogue difference signal, and an output for the second analogue difference signal.

In a preferred embodiment, the method further contains the steps of delaying the difference signal by a time delay. Preferably, the delaying step delays the first digital difference signal. The further preferred embodiment provides an advantage of timely aligning the input signal and the leveled difference signal at an adder for the sum signal and thereby maximizing noise suppression.

In embodiments, means for delaying the difference signal by the time delay may correspond to any delay unit such as a digital delay circuit, a negative retardation circuit, a variable delay line, an FIR filter (FIR = Finite Impulse Response) etc. Hence, in embodiments, the means for delaying the difference signal by the time delay may contain an input for the difference signal, an algorithm for performing a time shift of the difference signal according to the time delay and for obtaining the delayed difference signal for example by modifying filter coefficients of the FIR filter, and an output for the delayed difference signal. In some embodiments the means for determining the time delay can be implemented in terms of a computer program and a hardware component on which the computer program is executed, such as a DSP, an ASIC, an FPGA or any other processor.

According to a further improved embodiment, the method further contains the step of measuring a noise power level of the feedback signal, and determining a level factor for the leveling step according to the measured noise power level. The further improved embodiment provides the benefit of measuring directly the current noise power level of the feedback signal and using this measurement as an additional input parameter for the determination of the level factor.

Thereby, a reliability of the method for suppressing or canceling the signal noise can be improved because it allows for an iterative optimization method, which adapts the noise power suppression to aging effects and/or temperature effects.

In embodiments, means for measuring the noise power level of the feedback signal may correspond to any signal processing unit or any signal measuring unit such as a spectrum analyzer, a frequency selective RF power detector etc. Hence, in embodiments, the means for measuring the noise power level of the feedback signal may contain an input for the feedback signal, a measurement device for measuring the feedback signal and for obtaining the noise power level, and an output for the noise power level. In some embodiments the means for determining the time delay can be implemented in terms of a computer program and a hardware component on which the computer program is executed, such as a DSP, an ASIC, an FPGA or any other processor.

In embodiments, the means for determining the level factor for the leveling step may correspond to any determination unit such as a calculation unit, an optimization unit, an evaluation unit etc. Hence, in embodiments, the means for determining the level factor may contain an input for the difference signal, an algorithmic unit for determining a gain level based on a trend of noise power levels for various gain levels, a memory having storage space for performing the determination of the gain level and for storing the previous gain level and the previous level of the difference signal, and an output for the determined level factor. In some embodiments the means for determining the level factor can be implemented in terms of a computer program and a hardware component on which the computer program is executed, such as a DSP, an ASIC, an FPGA or any other processor.

Preferably, the measuring step of the noise power level and the determining step of the level factor may be performed by a first processing unit of the amplifier apparatus, the leveling step of the difference signal may be performed by a second processing unit of the amplifier apparatus and the method may further contains the step of providing at least one optimization parameter for the leveling step of the difference signal from the first processing unit to the second processing unit. Preferably, the at least one optimization parameter for the leveling step of the difference signal is provided, when the noise power level is above a predefined threshold.

In a further preferred embodiment, the method further contains the step of determining a time delay for the delaying step according to the measured noise power level. Thereby, a reliability of the method for suppressing or canceling the signal noise can be further improved because the time delay can be adapted to aging processes or temperature effects impact on the amplifier apparatus.

In embodiments, the means for determining the time delay for the delaying step may correspond to any determination unit such as a calculation unit, an optimization unit, an evaluation unit etc. Hence, in embodiments, the means for determining the time delay may contain an input for the difference signal, an algorithmic for iteratively determining the time delay, a memory having storage space for performing the determination of the time delay and/or for pre-calculated FIR coefficient sets for different time delays, and an output for the determined time delay. In some embodiments the means for determining the time delay can be implemented in terms of a computer program and a hardware component on which the computer program is executed, such as a DSP, an ASIC, an FPGA or any other processor.

A preset time delay value may be obtained for example by feeding an initial training signal to a beginning of the feedback path, capturing the training signal at an end of the feedback path and performing a cross correlation of the initial training signal and the captured training signal at an oscilloscope.

According to a further alternative embodiment, the determining step of the time delay may be performed by the first processing unit, the delaying step of the difference signal may be performed by the second processing unit and the method further contains the step of providing at least one optimization parameter for the determining step of the time delay from the first processing unit to the second processing unit. Preferably, the at least one optimization parameter for the determining step of the time delay is provided, when the noise power level is above the predefined threshold. The further preferred embodiment provides an advantage of adapting the time delay to aging effects and temperature effects of components of the amplifier apparatus, which otherwise can lead to significant signal mismatch in front of the adder. The optimization parameters may be only transmitted for noise power levels exceeding the predefined threshold.

In a further preferred embodiment, the determining step of the level factor and the determining step of the time delay are repeated by an optimization algorithm. Preferably, the both determining steps may be repeated until a decrease of a signal noise level between two repetitions is below a predefined threshold. Thereby, the signal noise level of the output signal of the amplifier apparatus can be further minimized.

Preferably, the first processing unit may be a pre-distortion unit of the amplifier apparatus. This allows using and extending components of the amplifier apparatus, which are already available in amplifier apparatuses such as a feedback path to the pre-distortion unit and the pre-distortion unit itself. Thereby, an extension with respect to the provision of the optimization parameters can be implemented without any additional components, which reduces implementation costs and fabrication costs.

Further advantageous features of the embodiments of the invention are defined and are described in the following detailed description.

**BRIEF DESCRIPTION OF THE FIGURES**

The embodiments of the invention will become apparent in the following detailed description and will be illustrated by accompanying figures given by way of non-limiting illustrations.

Figure 1 shows schematically a block diagram of an amplifier apparatus according to a first embodiment of the invention.

Figure 2 shows schematically a flow diagram of a method according to the first embodiment of the invention.

Figure 3 shows schematically a block diagram of a further amplifier apparatus according to a second embodiment of the invention.

Figure 4 shows schematically a block diagram of a pre-distortion unit according to the second embodiment of the invention.

Figure 5 shows schematically a flow diagram of a further method according to the second embodiment of the invention.

Figure 6 shows schematically a block diagram of a transmission apparatus, which contains an amplifier apparatus according to one of the embodiments of the invention.

Figure 7 shows schematically a block diagram of a network node, which contains a transmission apparatus with an amplifier apparatus according to one of the embodiments of the invention.

Figure 8 shows schematically a block diagram of a vehicle, which contains the network node according to Figure 7.

**DESCRIPTION OF THE EMBODIMENTS**

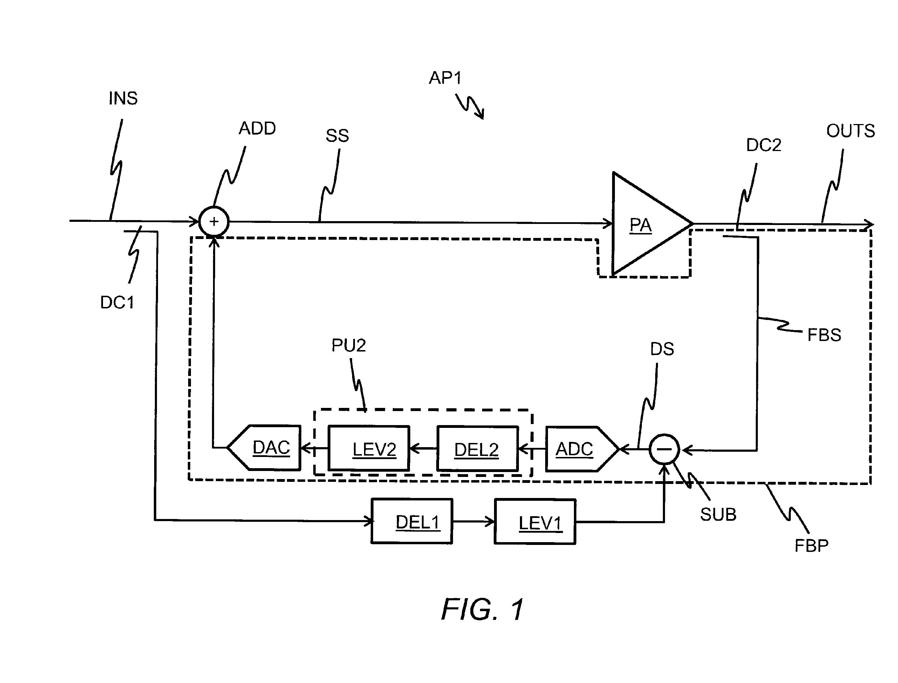

Figure 1 shows exemplarily an amplifier apparatus AP1 according to a first embodiment of the invention. The amplifier apparatus AP1 contains a first directional coupler DC1, an adding unit ADD, a power amplifier PA, a second directional coupler DC2, a subtracting unit SUB, an analogue-to-digital converter ADC, a first delaying unit DEL1, a first levelling unit LEV1, a digital-to-analogue converter DAC, a second delaying unit DEL2, a second levelling unit LEV2, and corresponding signalling lines between the above mentioned components and units of the amplifier apparatus AP1. The second delaying unit DEL2 and the second levelling unit LEV2 may be combined to one unit by multiplying for example coefficients of an FIR filter being the second delaying unit DEL2 by a levelling factor.
The first levelling unit LEV1 and the second delaying unit DEL2 are optional components and may be applied for further improving a performance of the amplifier apparatus AP1.
An analogue radio frequency input signal INS passes the first directional coupler DC1 being for example a 1 :3 coupler for extracting a smaller second input signal portion of the analogue radio frequency input signal INS for signal conditioning of an amplified output signal OUTS of the amplifier apparatus AP1. The signal conditioning may be for example noise suppression or noise cancellation. A larger first input signal portion of the analogue radio frequency input signal INS and a difference signal DS from a feedback path FBP are provided to the first adding unit ADD1 for generating a sum signal SS.
The sum signal SS is amplified by the power amplifier PA to the amplified output signal OUTS, which may contain two components according to following equation:

$$Z = Z_{MS} + Z_{noi} \qquad (0)$$

where $Z_{MS}$ is a useful component of the amplified output signal OUS and $Z_{noi}$ is a noise component of the amplified output signal OUTS. Useful component means in the following, that part of a signal, which contains the useful information such as data or voice. Noise component means in the following all parts of the signal, which contain signal distortions such as white noise. The power amplifier PA is assumed to be linear. Therefore, no further distortion is under consideration. The amplified output signal OUTS passes the second directional coupler DC2 for extracting a feedback signal FBS, which is used for the signal conditioning of the output signal of the amplifier apparatus AP1. The feedback signal FBS may be given by following relation:

$$fbs = \frac{z}{K1} = \frac{z_{MS} + z_{noi}}{K1} \qquad (1)$$

where *fbs* is the feedback signal FBS and $K1$ is a coupling factor of a 1: $K1$ coupling of the second directional coupler DC2.

A remaining larger part of the amplified output signal OUTS is provided for example to a duplexer (not shown in Figure 1 for simplification) or directly to a transmit antenna system (also not shown in Figure 1 for simplification).

The second input signal portion of the analogue radio frequency input signal INS is provided to the first delaying unit DEL1, which delays the second input signal portion of the analogue radio frequency input signal INS according to a first predefined time delay value to a delayed second input signal portion of the analogue radio frequency input signal INS. The first delaying unit DEL1 may be for example a piece of an electrical line or an electrical cable with a predefined length, which is adapted to the first predefined time delay value. A simple implementation may be for example a microstrip transmission line. The first predefined time delay value is preferably equal to and set to a signal run time and processing time beginning at the adding unit ADD, passing the power amplifier PA and the attenuation unit ATT and ending at the subtracting unit SUB. The first predefined time delay value may be obtained for example individually for each amplifier apparatus AP1 or as an average value across several amplifier apparatuses AP1 by generating a test signal with an oscilloscope, by applying the test signal to the adding unit ADD, by capturing the test signal at the subtracting unit SUB, which has been propagated along a signal path from the adding unit ADD to the subtracting unit SUB and processed by the power amplifier PA and the attenuation unit ATT, and by calculating a cross correlation of the test signal and the captured test signal at the oscilloscope.

Preferably, the delayed second input signal portion of the analogue radio frequency input signal INS is provided to the first levelling unit LEV1, which levels the delayed second input signal portion of the analogue radio frequency input signal INS to a further second input signal portion of the analogue radio frequency input signal INS for example by a predefined attenuation factor $K3$ to a same power level as the feedback signal FBS before the subtracting unit SUB. The first levelling unit LEV1 may be for example an RF tunable attenuator. The RF tunable attenuator may be for example an off-the-shelf voltage-controlled attenuator or an implementation of a network array of voltage controlled diodes.

In an alternative embodiment (not shown in Figure 1), the amplifier apparatus AP1 may not contain the first levelling unit LEV1 and an output signal of the first delaying unit DEL1 may be directly provided as an input signal to the subtracting unit SUB.

The feedback signal FBS and the further second input signal portion of the analogue radio frequency input signal INS are provided to the subtracting unit SUB, which subtracts the further second input signal portion of the analogue radio frequency input signal INS from the feedback signal FBS and generates a difference signal DS according to following equation:

$$ds = fbs - K3 \cdot x_{MS} \qquad (2)$$

where *ds* is the difference signal and $x_{MS}$ is the further second input signal portion of the analogue radio frequency input signal INS. The subtracting unit SUB may be for example a differential amplifier. In a simplest implementation of the subtracting unit SUB off-the-shelf op-amps may be configured in differential mode.

In further equation derivation (see below) it is assumed, that the first directional coupler DC1 is a 1:1 coupler, and the predefined attenuation factor K3 of the first levelling unit LEV1 has a value of 1.

The difference signal DS is provided to the first analogue-to-digital converter ADC1 for converting the difference signal DS being an analogue radio frequency signal into a digital difference signal DS. The digital difference signal DS is provided to a processing unit PU2, which may consist of the second levelling unit LEV2 and the second delaying unit DEL2 as separate processing units.

Alternatively, a single processing unit may contain both functionalities of the second levelling unit LEV2 and the second delaying unit DEL2 for example by multiplying the FIR filter coefficients of the second delaying unit DEL2 by the levelling factor of the second levelling unit LEV2. This means, the second levelling unit LEV2 may be an optional processing unit. Thereby, the digital difference signal DS may be only processed by the second delaying unit DEL2.

With respect to the embodiment shown in Figure 1, the digital difference signal DS is provided in a first sub-step to the second delaying unit DEL2, which performs a negative group delay according to a second predefined time delay value on signal components of the digital difference signal DS and generates a further digital difference signal DS. Preferably, the negative group delay is performed with respect to all useful signal components of the digital difference signal DS within a limited and predefined bandwidth of a transmit chain of the amplifier apparatus AP1.

The second delaying unit DEL2 may be for example a so-called FIR filter. The second predefined time delay value is preferably equal to and set to a signal run time along the feedback path FBP from the second directional coupler

6

DC2 to the adding unit ADD. The second predefined time delay value may be obtained for example individually for each amplifier apparatus AP1 or as an average value for several amplifier apparatuses by generating a further test signal with an oscilloscope, by applying the further test signal to the second directional coupler DC2, by capturing the further test signal at the adding unit ADD, which has been propagated along the signal path from the second directional coupler DC2 to the adding unit ADD and processed by the attenuation unit ATT, the subtracting unit SUB, the analogue-to-digital converter ADC, the second delaying unit DEL2, the second levelling unit LEV2 and the digital-to-analogue converter DAC, and by calculating a cross correlation of the further test signal and the further captured test signal at the oscilloscope.

The second predefined time delay is then applied for calculating individual coefficients for the FIR filter for example in a following way:

$$H\_NEG(del) = conv\big(H1(n), H2(n + del)\big) \qquad (3)$$

where:

$del$ denotes number of the negative group delay with unit of sampling period,

$conv()$ represents a convolution of FIR filters $H1(n)$ and $H2(n + del)$,

$H1(n)$ has a digital delay of $n$ samples and can be any type of FIR filters, and

$H2(n)$ has a special form and is given by $H2(n) = [2,0,0, ..., -1]$ with n-1 zeros between 2 and -1.

The further digital difference signal DS is then provided in a further sub-step to the second levelling unit LEV2, which levels the further digital difference signal DS to an even further digital difference signal DS by a further level factor or attenuation factor $K2$. The second levelling unit LEV2 may be for example a multiplier. The digital difference signal DS is applied to the digital-to-analogue converter DAC, which converts the digital difference signal DS again into a further analogue difference signal DS.

A suitable value for the predefined or preset attenuation factor $K2$ may be obtained for example according to following considerations:

The amplified output signal $Z$ can be written in a first instant of time, when the first input signal portion of the analogue radio frequency input signal INS is amplified by the power amplifier PA a first time (no noise is fed back via the feedback path FBP), by following equation:

$$z_1 = z_{MS} + z_{noi} = x_{MS} \cdot G + z_{noi} \qquad (4)$$

where G represents a gain factor of the power amplifier PA.

A relation for amplitude values of the difference signal DS may be given at the first instant of time for example by following equation (see equation (2)):

$$ds = \frac{z_1/K1 - x_{MS}}{K2} \qquad (5)$$

An amplitude value of the sum signal SS at the first instant of time may be given by following equation:

$$y_1 = x_{MS} + ds = x_{MS} + \frac{z_1/K1 - x_{MS}}{K2} = \frac{z_1/K1 + (K2-1) \cdot x_{MS}}{K2} \qquad (6)$$

where $y_1$ is the sum signal SS.

The amplified output signal OUTS may be given at the first instant of time by following equation:

$$z_1 = y_1 \cdot G + z_{noi} = \frac{z_1/K1 + (K2-1) \cdot x_{MS}}{K2} + z_{noi} \qquad (7)$$

By substituting equation (4) into equation (7) following relation is given:

$$z_1 = \frac{(x_{MS} \cdot G + z_{noi})/K1 + (K2-1) \cdot x_{MS1}}{K2} + z_{noi} \qquad (8)$$

Equation (8) can be converted into following equation:

$$z_1 = \frac{(K2 \cdot K1 - K1 + G) \cdot G}{K1 \cdot K2} \cdot x_{MS} + \frac{(K1 \cdot K2 + G)}{K1 \cdot K2} \cdot z_{noi} \qquad (9)$$

By applying a fixed gain factor G and by applying at the second directional coupler DC2 a 1: G coupling, which means **K1** is equal to **G,** following equation is obtained:

$$z_1 = G \cdot x_{MS} + \frac{(K2+1)}{K2} \cdot z_{noi} \qquad (10)$$

By comparing equation (10) with equation **(4)** it can be concluded, that the noise component $Z_{noi}$ of the amplified output signal OUTS can be completely eliminated, when the further predefined attenuation factor **K2** is set to **-1.** When comparing the above considerations of a memoryless power amplifier model with the real power amplifier PA and certain time delay in the amplifier apparatus PA1, an improvement of up to 20 dB noise reduction can be achieved by the amplifier apparatus AP1 with respect to conventional amplifier apparatuses, when the further predefined attenuation factor **K2** may be set and predefined to a value slightly different to **-1** such as **-0.9** or in a range around -G/K1.

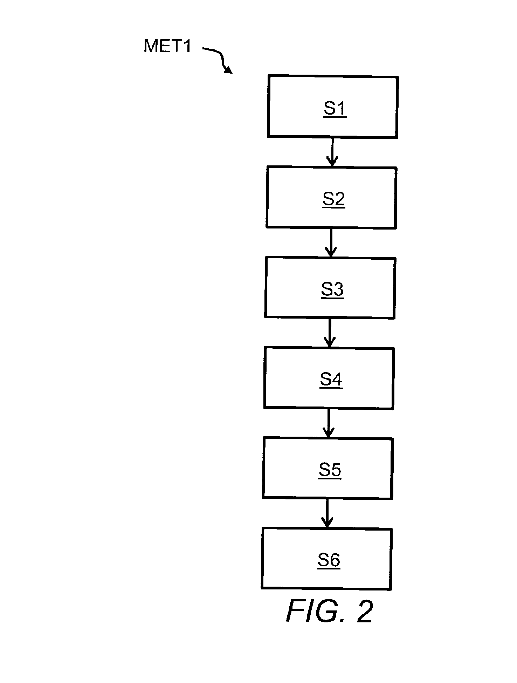

Figure 2 shows a flow diagram of a method MET1 in accordance to the embodiment of the amplifier apparatus AP1, which is shown in Figure 1. The number of the steps for performing the method MET is not critical, and as can be understood by those skilled in the art, that the number of the steps and the sequence of the steps may vary without departing from the scope of the embodiments of the invention as defined in the appended claims.

In a first step S1, the difference signal DS is generated by the subtracting unit SUB from the input signal INS of the amplifier apparatus AP1 and the feedback signal FBS according to equation (2).

In a next step S2, the difference signal DS is converted by the analogue-to-digital converter ADC from an analogue signal into a digital signal.

By a further step S3, the difference signal DS is delayed in time by the second delaying unit DEL2 according to equation (3).

In a next step S4, the difference signal DS is levelled by the second levelling unit LEV with the further attenuation factor **K2** (see equation (5) for an overall processing of the difference signal DS).

In a further step S5, the difference signal DS is converted by the digital-to-analogue converter DAC from a digital signal into an analogue signal.

By a next step S6, the sum signal SS of the input signal INS and the difference signal DS is amplified by the power amplifier PA for generating the amplified output signal OUTS.

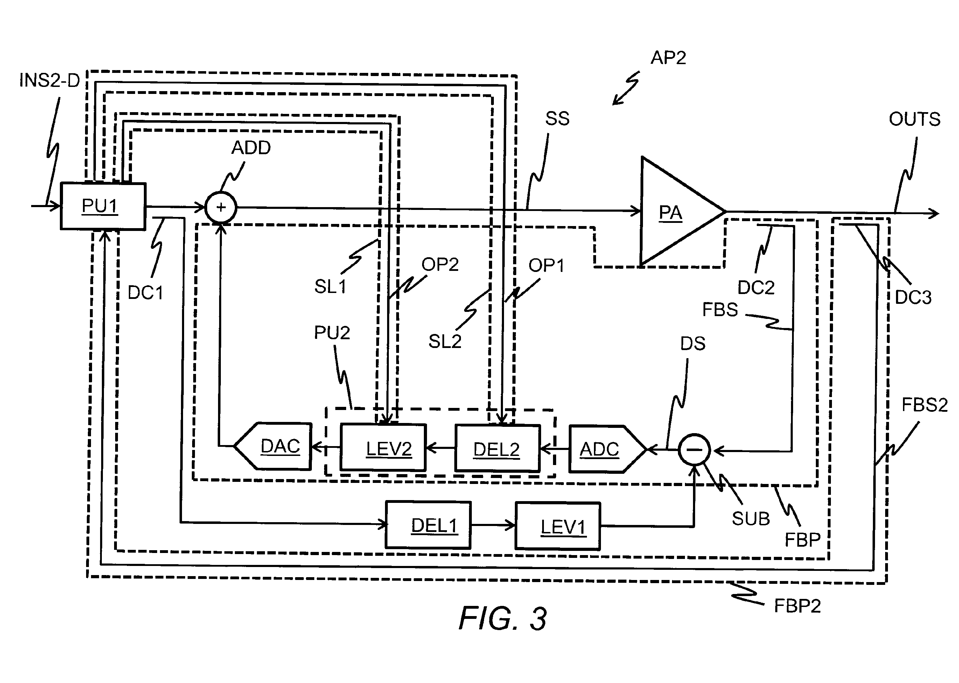

Figure 3 shows a further amplifier apparatus AP2 according to a second embodiment of the invention. The amplifier apparatus AP2 contains all components and units of the amplifier apparatus AP1 and in addition a third directional coupler DC3, a processing unit PU1, a further feedback path FBP2 for a further feedback signal FBS2 from the third directional coupler DC3 to the processing unit PU1, a signalling line SL1 for one or several first optimization parameters OP1 from the processing unit PU1 to the second levelling unit LEV2 and a further signalling line SL2 for one or several second optimization parameters OP2 from the processing unit PU1 to the second delaying unit DEL2.

The third directional coupler DC3 may preferably apply a coupling with a same factor as applied by the second directional coupler DC2. Alternatively, the third directional coupler DC3 may apply a different coupling factor such as 1:1000.

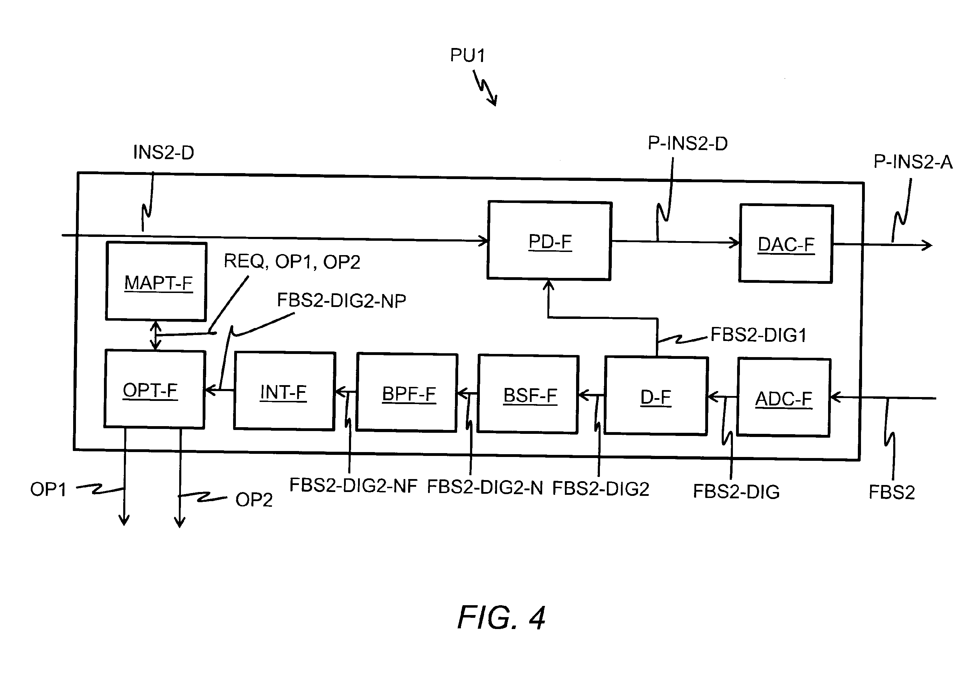

The processing unit PU1 as shown in Figure 3 is preferably a pre-distortion unit. In an alternative embodiment (not shown in Figure 4), the further feedback signal FBS2 may be split by a splitter in two equal or non-equal analogue signals, a first one of the two analogue signals may be provided to a conventional pre-distortion unit and a second one of the two analogue signals may be provided to a further processing unit for measuring and determining the noise power of the second one of the two analogue signals. Alternatively, the pre-distortion unit and the further processing unit may be fed back by separate feedback signals, which has been extracted from the amplified output signal OUTS by two directional couplers.

The pre-distortion unit may perform an analogue signal processing of an input signal being an analogue radio frequency signal (not shown in Figure 3) or may perform a digital signal processing of an input signal INS2-D being a digital radio frequency signal (as shown in Figure 3 and Figure 4).

The processing unit PU1 measures or determines a noise component of the further feedback signal FBS2. Such a measurement or determination may be done for example in a following way as shown in Figure 4. The processing unit PU1 may be for example a pre-distortion processing unit and may contain for example following functionalities: an analogue-to-digital converter function ADC-F, a doubling function D-F, a conventional pre-distortion function PD-F, a digital-to-analogue converter function DAC-F, a band stop filter function BSF-F, a band pass filter function BPF-F, an integrator function INT-F, an optimization function OPT-F, and optionally a mapping table function MAPT-F. In addition, the processing unit PU1 may contain an input for the input signal INS2-D being a digital input signal, an input for the further feedback signal FBS2, an output for a pre-distorted input signal P-INS2-A being an analogue input signal, and one output (not shown in Figure 4) or two outputs for a first optimization parameter OP1 and a second optimization parameter OP2.

The further feedback signal FBS2 is provided to the analogue-to-digital converter function ADC-F for converting the further feedback signal FBS2 being an analogue radio frequency signal to a digital feedback signal FBS2-DIG being a digital bit stream. The digital feedback signal FBS2-DIG is provided to the doubling function D-F, which doubles a bit stream from the analogue-to-digital converter function ADC-F into two equal bit streams FBS2-DIG1, FBS2-DIG2.

A first bit stream FBS2-DIG1 is provided to the convention pre-distortion function PD-F, which applies a digital pre-distortion with respect to the digital input signal INS2-D and thereby generates a pre-distorted digital input signal P-INS2-D. The pre-distorted digital input signal P-INS2-D is provided to the digital-to-analogue converter function DAC-F, which generates the pre-distorted analogue input signal P-INS2-A.

A second bit stream FSB2-DIG2 is provided to the band stop filter function BSF-F, which blocks the useful signal components of the second bit stream FSB2-DIG2 within a predefined frequency bandwidth such as 2.64 GHz to 2.65 GHz. The band stop filter function BSF-F may be generated for example by a tool such as Matlab. An output signal FBS2-DIG2-N is provided to the band pass filter function BPF-F, which has for example a predefined band pass from 2.62 GHz to 2.69 GHz, and let pass noise components FBS2-DIG2-NF of the second bit stream FSB2-DIG2 in frequency ranges from 2.62 GHz to 2.64 GHz and from 2.65 GHz to 2.69 GHz. The noise components FBS2-DIG2-NF are provided to the integrator function INT-F, which performs integration across the predefined frequency range such from 2.62 GHz to 2.64 GHz and from 2.65 GHz to 2.69 GHz and determines a noise power FBS2-DIG2-NP for the noise components FBS2-DIG2-NF. A serial arrangement of the band stop filter function BSF-F and the band pass filter function BPF-F may be changed. According to a further alternative, both filter functions BSF-F and BPF-F may be integrated into a single filter function. The noise power FBS2-DIG2-NP is provided to the optimization function OPT-F. The optimization function OPT-F may operate according to two consecutive optimization cycle.

Alternatively, the further feedback signal FBS2 may be converted to a baseband signal or an IF band signal (IF = intermediate frequency) by a mixer, and then fed to the processing unit PU1. In this way the processing unit PU1 may be operated with relative low sampling rate of a few hundreds of MHz or even lower. Thereby, the band pass filter function BPS-F between the band stop filter function BSF-F and the integrator function INT-F may be eventually avoided.

In a first step of a first optimization cycle, the noise power FBS2-DIG2-NP is measured and determined for a preset set of filter coefficients. Then, one of a set of filter coefficients of the FIR filter, which may be calculated for example by equation (3) (see also mapping table below), is increased or decreased or extended with a predefined principle and amount, and the filter coefficient is provided as a first optimization parameter OP1 from the optimization function OPT-F to the second delaying unit DEL2, which applies the filter coefficient in the following. After waiting a predefined waiting period of for example 1 ms, the optimization function OPT-F evaluates, whether a newly determined noise power FBS2-DIG2-NP is smaller than a previous determined noise power FBS2-DIG2-NP. If for example the filter coefficient has been increased and the noise power FBS2-DIG2-NP is decreased, in a second step of the first optimization cycle, the filter coefficient is further increased as long as the noise power FBS2-DIG2-NP does not further decrease. If for example the filter coefficient has been increased and the noise power FBS2-DIG2-NP is increased, in the second step the filter coefficient might be decreased with the predefined amount with respect to the originally preset or predefined value. After waiting the predefined waiting period, the optimization function OPT-F evaluates, whether a newly determined noise power FBS2-DIG2-NP is smaller than the previous determined noise power FBS2-DIG2-NP. This iterative method may be applied for a first filter coefficient of the FIR filter as long as the noise power FBS2-DIG2-NP does not further decrease. The iterative method may be applied for further filter coefficients of the FIR filter as long as the noise power FBS2-DIG2-NP does not further decrease. During the first optimization cycle, the attenuation factor *K2* may be kept constant.

In a first step of a second optimization cycle, the noise power FBS2-DIG2-NP is measured and determined for a preset attenuation factor *K*2 such as the predefined attenuation factor *K2* given above or according to equation *K*2 = -*G*/*K*1. Then, a new attenuation factor **K2** is determined by increasing or decreasing the preset attenuation factor **K2** with a predefined amount. The newly determined attenuation factor **K2** is provided as a second optimization parameter OP2 from the optimization function OPT-F to the second levelling unit LEV2 and is applied at the second levelling unit LEV2 in the following. After waiting the predefined waiting period, the optimization function OPT-F evaluates, whether a newly determined noise power FBS2-DIG2-NP is smaller than the previous determined noise power FBS2-DIG2-NP. If for example the attenuation factor **K2** has been increased and the noise power FBS2-DIG2-NP is decreased, in a second step of the second optimization cycle, the attenuation factor **K2** is further increased as long as the noise power FBS2-DIG2-NP does not further decrease. If for example the attenuation factor **K2** has been increased and the noise power FBS2-DIG2-NP is increased, in the second step the attenuation factor **K2** might be decreased with the predefined amount from the originally predefined value. After waiting the predefined waiting period, the optimization function OPT-F evaluates, whether a newly determined noise power FBS2-DIG2-NP is smaller than the previous determined noise power FBS2-DIG2-NP. This iterative method may be applied as long as the noise power FBS2-DIG2-NP does not further decrease. During the second optimization cycle, the coefficients [-0.01168, 0.00398, 0.039831, -0.003351, 1.9429, -0.003351, 0.039831, 0.009816, - 0.013668, -0.019915, 0.001675, -0.97145, 0.001675, -0.01992, -0.001988, 0.00584] of the FIR filter may be kept constant.

Instead of the above described iterative methods, new optimization parameters OP1, OP2 may be determined by alternative iterative method, which applies the mapping table function MAPT-F. The mapping table function MAPT-F may contain a first mapping table 1 as shown below for predefining filter coefficients to be applied at the second delaying unit DEL2:

Mapping table for filter coefficients

| Operating frequency [GHz] | Negative group delay value for second delaying unit DEL2 [ns] | Set of filter coefficients for a sampling rate of 15 GHz |
|---|---|---|
| 2.14 | -0.07 | [0.001771, -0.005104, -0.01540, 0.0133674, 0.04450, -0.008356, 1.938257, -0.009241, 0.047049, 0.021067, -0.022082, -0.027353, 0.005949, -0.969129, 0.004178, -0.022248, -0.006684, 0.00770, |
| | | 0.002552234, -0.000885358] |
| | -0.14 | [-0.00606, -0.00958, 0.016053, 0.035501, -0.010086, 1.948073, -0.01009, 0.03853, 0.020843, -0.017607, -0.02381, 0.005043, -0.97404, 0.005043, -0.01775, -0.008027, 0.00479, 0.003028] |
| | -0.21 | [-0.01168, 0.00398, 0.039831, -0.003351, 1.9429, -0.003351, 0.039831, 0.009816, -0.013668, -0.019915, 0.001675, -0.97145, 0.001675, -0.01992, -0.001988, 0.00584] |
| | -0.28 | [0.00223, 0.004055, -0.001966, 1.99242, -0.001966, 0.004055, 0.00223, -0.00111, -0.00203, 0.00098, -0.99621, 0.000983, -0.002028, -0.001115,] |
| | Y1_1 | Z1_1 |
| | Y1_2 | Z1_2 |
| X | Y2_1 | Z2_1 |
| | Y2_2 | Z2_2 |

The first mapping table contains in a first column several operating frequencies (only a first operating frequency is shown for simplification; a further operating frequency is only indicated by "X"). The first mapping table further contains in a second column four negative group delay values for the operating frequency (further negative group delay values are not shown for simplification and are only indicated by "Y1_1" and "Y1_2" for the first operating frequency and by "Y2_1" and "Y2_2" for the further operating frequency). Alternatively, the second column may contain ten, fifteen or even more negative group delay values for the operating frequency. The first mapping table further contains in a third column sets of filter coefficients for each negative group delay value to be applied at the second delaying unit DEL2 (further sets of filter coefficients are not shown for simplification and are only indicated by "Z1_1" and "Z1_2" for the first operating frequency and by "Y2_1" and "Y2_2" for the further operating frequency). Optionally, the first mapping table may be extended by a further column with three, five or even more temperature ranges for each operating frequency.

Dependent on a newly applied operating frequency, the optimization function OPT-F may request at the beginning of the optimization process a set of filter coefficients as the first optimization parameters OP1 for example for a medium negative group delay from the mapping table function MAP-F, which may be for example a set of filter coefficients for the -0.14 ms negative group delay value. The set of filter coefficients is provided as the first optimization parameter OP1 from the optimization function OPT-F to the second delaying unit DEL2 (see Figure 3). After waiting the predefined waiting period for measuring and determining the noise power FBS2-DIG2-NP, the optimization function OPT-F requests REQ for example an increased negative group delay value a new set of filter coefficients and provides the new set of filter coefficients also as the first optimization parameter OP1 from the optimization function OPT-F to the second delaying unit DEL2. After waiting again the predefined waiting period for measuring and determining the noise power FBS2-DIG2-NP, the optimization function OPT-F evaluates, whether the newly determined noise power FBS2-DIG2-NP based on the newly applied set of filter coefficients is smaller than the previous determined noise power FBS2-DIG2-NP. If it is true, the negative group delay value may be further increased as long as the noise power FBS2-DIG2-NP does not further decrease.

In a similar way, the mapping table function MAPT-F may optionally contain a second mapping table for attenuation factors $K2$ to be applied at the second levelling unit LEV2. In such a case, the second mapping table may contain in a first column the several operating frequencies and in a second column for example five attenuation factors $K2$ for each operating frequency. Preferably, the second mapping table may further contain in a further column filter three, five or even more temperature ranges for each operating frequency.

The sets of filter coefficients of the first mapping table and the attenuation factors $K2$ of the second mapping table may be obtained for example by calibration at different operating frequencies and different temperatures for a single amplifier apparatus AP2 or as average values for a calibration performed at several amplifier apparatuses AP2.

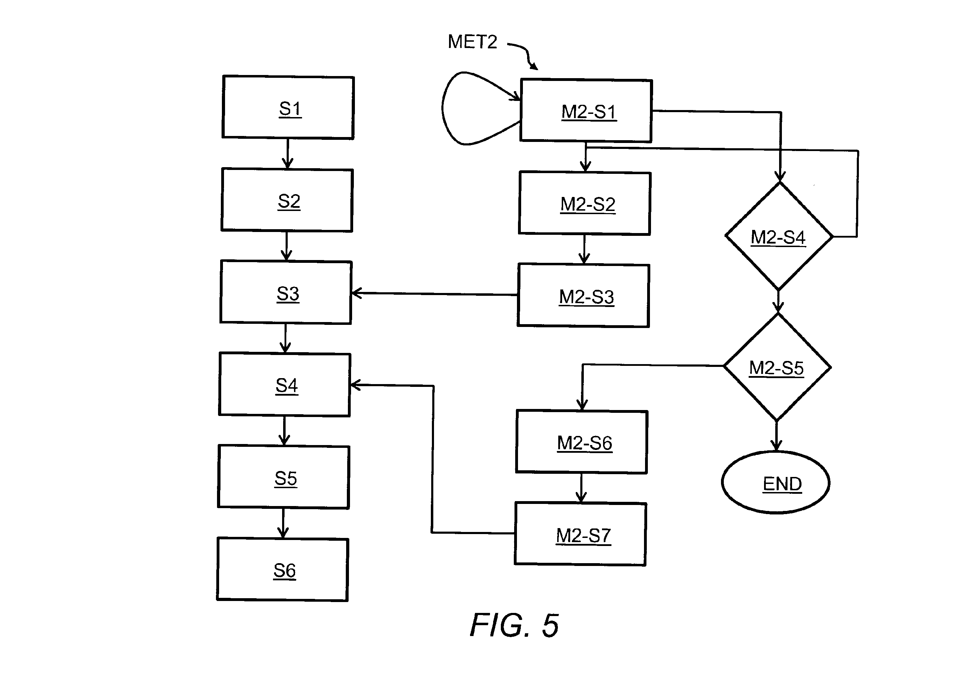

Figure 5 shows a flow diagram of a method MET2 in accordance to the embodiment of the amplifier apparatus AP2, which is shown in Figure 3. The number of the steps for performing the method MET2 is not critical, and as can be understood by those skilled in the art, that the number of the steps and the sequence of the steps may vary without departing from the scope of the embodiments of the invention as defined in the appended claims. In addition to the steps S1 to S6 of the method MET1, the method MET2 further contains the steps MS2-S1, MS2-S2, MS2-S3, MS2-S4, MS2-S5, MS2-S6, and MS2-S7.

In a first additional step MS2-S1, the first processing unit PU1 measures and determines as described above according to Figure 4 the noise power FBS2-DIG2-NP for preset values of the filter coefficients and of the attenuation factor $K2$. The step MS2-S1 may be repeated until the method MET2 arrives at an end point END.

In a next step MS2-S2, the first processing unit PU1 determines a new set of filter coefficients and thereby a new time delay to be applied at the second delaying unit DEL2 as described above regarding Figure 4.

In a further step MS2-S3, the first processing unit PU1 provides the new set of filter coefficients as the first optimization parameters OP1 to the second processing unit PU2 and the second delaying unit DEL2, which delays the difference signal DS in the following according to the new time delay in the step S3.

In a step M2-S4 in parallel to the step MS2-S1, the first processing unit PU1 evaluates, whether a further decreasing of the noise power FBS2-DIG2-NP may be approachable by an adaptation of one or several of the filter coefficients. If yes, the step M2-S2 may be the next step. If no, step M2-S5 may be the next step.

In the further step M2-S5, the first processing unit PU1 evaluates, whether a further decreasing of the noise power FBS2-DIG2-NP may be approachable by an adaptation of the attenuation factor $K2$. If yes, the step M2-S6 may be the next step. If no, the method MET2 ends.

In the next step M2-S6, the first processing unit PU1 determines a new attenuation factor $K2$ to be applied at the second levelling unit LEV2 as described above regarding Figure 4.

In a further step M2-S7, the first processing unit PU1 provides the new attenuation factor $K2$ as the second optimization parameter OP1 to the second processing unit PU2 and the second levelling unit LEV2, which levels the difference signal DS in the following according to the new attenuation factor $K2$ in the step S4.

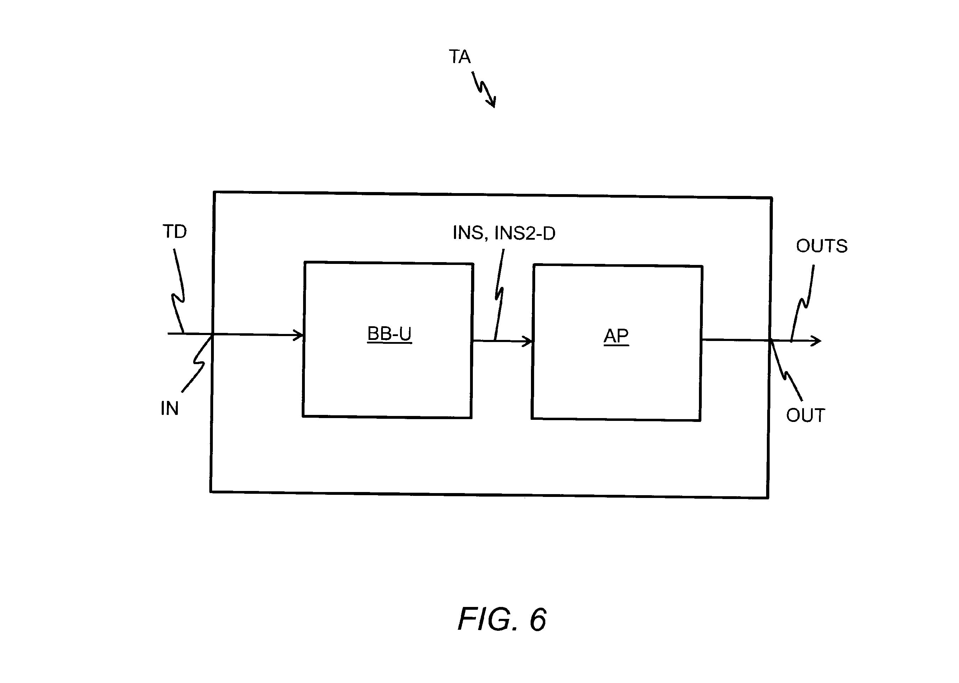

Figure 6 shows a transmitter apparatus TA which contains an input IN for transmitting data TD such as user data or signalling data to be transmitted to a receiver. The transmitter apparatus TA further contains a so-called baseband processing unit BB-U, which generates input radio frequency signal INS, INS2-D for an amplifier apparatus AP. The input radio frequency signal INS, INS2-D contain the data DT by applying a predefined modulation and a predefined coding. The transmitter apparatus TA further contains the amplifier apparatus AP for amplifying the input radio frequency signal INS, INS2-D to the amplified output signal OUTS. The amplifier apparatus AP may be the amplifier apparatus AP1 or the amplifier apparatus AP2. The transmitter apparatus TA further contains an output OUT for the amplified output signal OUTS. An antenna system is usually connected to the output OUT.

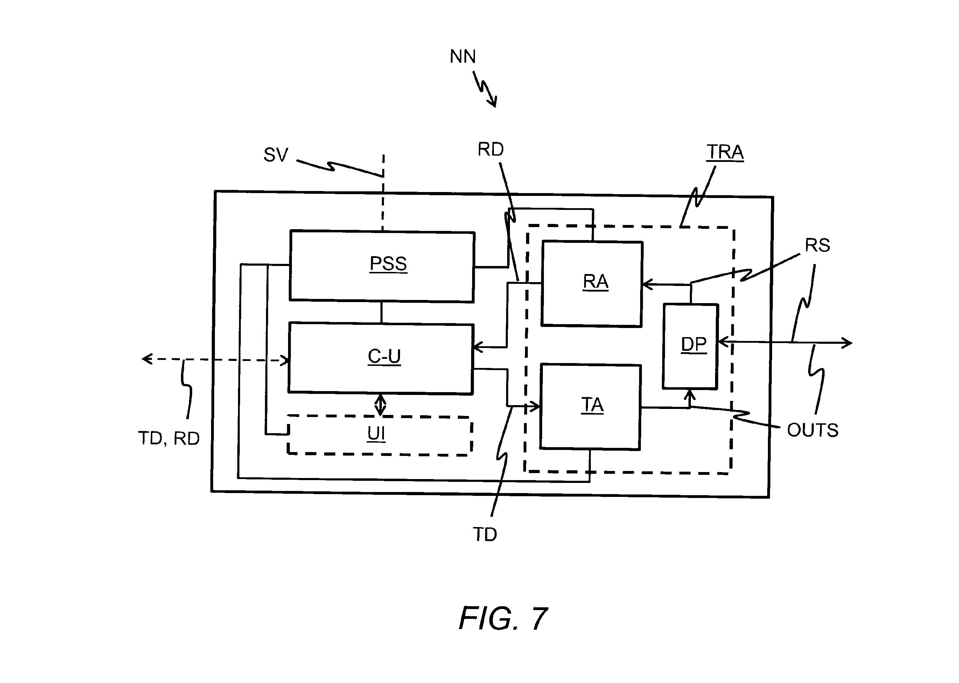

The transmitter apparatus TA may be a transmitter or radio transmitter. The transmitter apparatus TA may be part of a transceiver apparatus, which contains the transmitter apparatus TA and a receiver apparatus. Figure 7 shows a network node NN for use in a radio communication system. The network node NN may be for example a base station, a mobile station, a repeater or a relay. The exemplarily network node NN contains a power supply system PSS for providing electrical power to components of the network node NN.

When the network node NN is a base station, a supply voltage SV may be applied externally to the power supply system PSS. When the network node NN is a mobile station, the network node NN may further contain an graphical user interface UI such as a touch-sensitive display of a so-called smartphone.

The network node NN further contains a control unit C-U for controlling all components of the network node NN. The control unit C-U may contain a CPU (CPU = central processing unit) and a memory. When the network node NN is for example a mobile station, the control unit C-U may for example run applications or so-called apps. When the network node NN is for example a base station, the transmission data TD may be provided externally to the network node NN or reception data RD may be transmitted from the network node NN to a further network node of the radio communication system.

The network node NN further contains a transceiver TRA. The transceiver TRA contains the transmitter apparatus TA, a receiver apparatus RA and a duplexer DP for splitting and merging the amplified output radio frequency signal OUTS and a received radio frequency signal RS.

The transmission data TD may be provided from the control unit C-U to the transmitter apparatus TA and the reception data RD may be provided from the receiver apparatus RA to the control unit C-U.

The term "base station" may be considered synonymous to and/or referred to as a base transceiver station, base station, Node B, enhanced Node B, access point, a femtocell, a femto base station, a picocell, a pico base station etc. and may describe equipment that provides connectivity via a radio link between the radio communication system RCS and one or more mobile stations. The term "radio cell" is considered synonymous to and/or is referred to as radio cell, cell, radio sector, sector etc.

The term "mobile station" may be considered synonymous to, and may hereafter be occasionally referred to, as a mobile unit, mobile station, mobile user, access terminal, user equipment, subscriber, user, remote station etc. The mobile station may be for example cellular telephones, portable computers, pocket computers, hand-held computers, personal digital assistants, USB flash drives with a radio interface or car-mounted mobile devices.

The term "repeater" may be considered synonymous to and/or referred to as an electronic device that receives a signal and simply retransmits it at a higher level or higher power, or onto another side of an obstruction, so that the signal can cover longer distances.

The term "relay" may be considered synonymous to and/or referred to as an electronic device that receives a signal and retransmits a different signal not only at a higher level or higher power, but also at a different frequency and/or different time slot and/or spreading code, to increase capacity in a wireless access network and to improve wireless link performance.

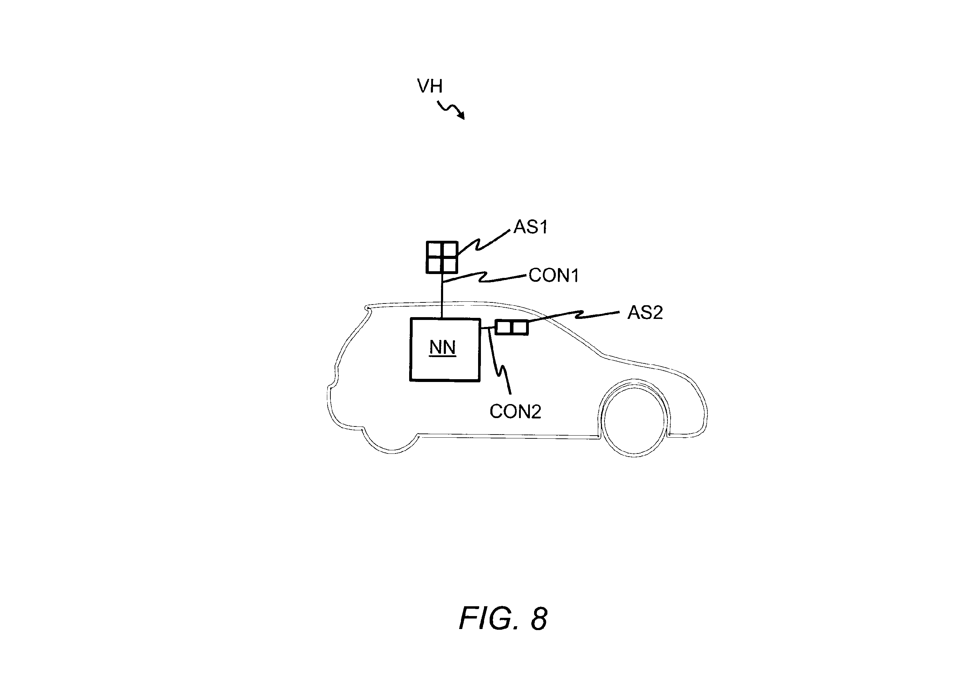

Referring to Figure 8 a block diagram of a vehicle VH is shown. The vehicle VH contains the access network node NN for providing wireless access between vehicle occupants inside the vehicle VH and a radio access network such as based on UMTS (UMTS = Universal Mobile Telecommunications System), LTE (LTE = Long Term Evolution) or LTE Advanced. The vehicle VH further contains a first antenna system AS1, which is located outside the vehicle VH and which is connected to the network node NN via a first connection CON1. The vehicle VH further contains a second antenna system AS2, which is located inside the vehicle VH and which is connected to the network node NN via a second connection CON2. The network node NN may act for example towards the radio access network as a mobile station and may act towards the mobile stations located inside the vehicle VEH as a base station or femtocell. Alternatively, the network node NN may be a repeater or a relay.

The vehicles VH is shown exemplarily as a car. The term "verhicle" may be further considered synonymous to and/or referred to a lorry, a bus, a train, a streetcar or tramway, a ship, a plane etc.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks denoted as "means for generating", "means for determining" etc. (performing a certain function) shall be understood as functional blocks comprising circuitry that is adapted for performing a certain function, respectively. Hence, a "means for s.th." may as well be understood as a "means being adapted or suited for s.th.". A means being adapted for performing a certain function does, hence, not imply that such means necessarily is performing said function (at a given time instant).

Functions of various elements shown in the figures, including any functional blocks may be provided through the use of dedicated hardware, as e.g. a processor, as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the detailed description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods. Preferably, a computer program product may contain computer-executable instructions for performing the method MET1 or the method MET2, when the computer program product is executed on a programmable hardware device such as a DSP, an ASIC or an FPGA. Preferably, a digital data storage device may encode a machine-executable program of instructions to perform the method MET1 or the method MET2.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

**Claims**

1. A method (MET1, MET2) for signal amplification in an amplifier apparatus (AP, AP1, AP2), said method (MET1, MET2) comprising the steps of:

    - generating (S1) a difference signal (DS) from an input signal (INS, INS2-D) of said amplifier apparatus (AP, AP1, AP2) and a feedback signal (FBS) of said amplifier apparatus (AP, AP1, AP2),
    - leveling (S4) said difference signal (DS) by a digital signal processing of said difference signal (DS), and
    - amplifying (S6) a sum signal SS() of said input signal (INS, INS2-D) and of said leveled difference signal (DS) by a power amplifier (PA) for generating an amplified output signal (OUTS) of said amplifier apparatus (AP, AP1, AP2).

2. Method (MET1, MET2) according to claim 1, wherein said leveling step (S4) of said difference signal (DS) by said digital signal processing comprises:

    - converting said difference signal (DS) from a first analogue difference signal into a first digital difference signal, and
    - converting said leveled difference signal (DS) from a second digital difference signal into a second analogue difference signal,

    and wherein said leveling step (S4) levels said first digital difference signal to said second digital difference signal.

3. Method (MET1, MET2) according to any of the preceding claims, wherein said method further comprises the step of delaying (S3) said difference signal (DS) by a time delay.

4. Method (MET2) according to any of the preceding claims, wherein said method (MET2) further comprises the steps of:

    - measuring (M2-S1) a noise power level (FBS2-DIG2-NP) of said feedback signal (FBS), and

- determining (M2-S5) a level factor for said leveling step (S4) according to said measured noise power level (FBS2-DIG2-NP).

5. Method (MET2) according to claim 4, wherein said measuring step (M2-S1) of said noise power level (FBS2-DIG2-NP) and said determining step (M2-S5) of said level factor are performed by a first processing unit (PU1) of said amplifier apparatus (AP2), wherein said leveling step (S4) of said difference signal (DS) is performed by a second processing unit (PU2) of said amplifier apparatus (AP2) and wherein said method (MET2) further comprises the step of providing (M2-S6) at least one optimization parameter (OP2) for said leveling step (S4) of said difference signal (DS) from said first processing unit (PU1) to said second processing unit (PU2).

6. Method (MET2) according to claim 3 and claim 4, wherein said method (MET2) further comprises the step of determining (M2-S2) a time delay for delaying step (S3) according to said measured noise power level (FBS2-DIG2-NP).

7. Method (MET2) according to claim 6, wherein said determining step (M2-S1) of said time delay is performed by said first processing unit (PU1), wherein said delaying step (S3) of said difference signal (DS) is performed by said second processing unit (PU2) and wherein said method (MET2) further comprises the step of providing (M2-S3) at least one optimization parameter (OP1) for said determining step (M2-S2) of said time delay from said first processing unit (PU1) to said second processing unit (PU2).

8. Method (MET2) according to claim 4 and claim 6, wherein said determining step (M2-S5) of said level factor and said determining step (M2-S2) of said time delay are repeated by an optimization algorithm.

9. A computer program product comprising computer-executable instructions for performing a method according to any of the preceding claims when the computer program product is executed on a programmable hardware device.

10. A digital data storage device encoding a machine-executable program of instructions to perform a method according to any of the preceding claims 1 to 8.

11. An amplifier apparatus (AP, AP1, AP2) for signal amplification, said amplifier apparatus (AP, AP1, AP2) comprising:

- means (SUB) for generating a difference signal (DS) from an input signal (INS, INS2-D) of said amplifier apparatus (AP, AP1, AP2) and a feedback signal (FBS) of said amplifier apparatus (AP, AP1, AP2),
- means (LEV2) for leveling said difference signal (DS) by a digital signal processing of said difference signal (DS), and
- means (PA) for amplifying a sum signal (SS) of said input signal (INS, INS2-D) and of said leveled difference signal (DS) for generating an amplified output signal (OUTS) of said amplifier apparatus (AP, AP1, AP2).

12. Amplifier apparatus (AP, AP1, AP2) according to claim 11, wherein said amplifier apparatus (AP, AP1, AP2) is an amplifier apparatus for radio frequency signals.

13. A transmitter apparatus (TA) comprising an amplifier apparatus (AP, AP1, AP2) according to claim 11 or claim 12.

14. A network node (NN) comprising a transmitter apparatus (TA) according to claim 13.

15. A vehicle (CH) comprising a network node (NN) according to claim 14.

FIG. 1

EP 2 790 321 A1

FIG. 2

FIG. 3

EP 2 790 321 A1

PU1

INS2-D

P-INS2-D

P-INS2-A

*FIG. 4*

EP 2 790 321 A1

EP 2 790 321 A1

MET2

S1

S2

S3

S4

S5

S6

M2-S1

M2-S2

M2-S3

M2-S4

M2-S5

M2-S6

M2-S7

END

*FIG. 5*

EP 2 790 321 A1

TA

TD

INS, INS2-D

OUTS

IN

| BB-U | | AP |

OUT

*FIG. 6*

FIG. 7

EP 2 790 321 A1

VH

AS1

CON1

AS2

NN

CON2

**FIG. 8**

Europäisches
Patentamt

European
Patent Office

Office européen
des brevets

## EUROPEAN SEARCH REPORT

Application Number

EP 13 30 5460

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/212428 A1 (ODE TAKAYOSHI [JP] ET AL) 28 October 2004 (2004-10-28) * paragraph [0096] - paragraph [0097]; figure 13 * ----- | 1,3,9-15 | INV. H03F1/26 H04B1/04 |
| X | US 2005/085199 A1 (KHAN ANDREW M [US] ET AL) 21 April 2005 (2005-04-21) * paragraph [0015] - paragraph [0021]; figure 1 * ----- | 1,3,9-15 | |
| X | EP 1 835 626 A1 (FUJITSU LTD [JP]) 19 September 2007 (2007-09-19) * paragraph [0026] - paragraph [0043]; figures 5,6 * ----- | 1,3,9-15 | |
| X | EP 1 199 814 A1 (FUJITSU LTD [JP]) 24 April 2002 (2002-04-24) * paragraph [0024] - paragraph [0027]; figures 1,2 * ----- | 1,9-15 | |
| X | US 2002/097811 A1 (KUBO TOKURO [JP] ET AL) 25 July 2002 (2002-07-25) * paragraph [0051] - paragraph [0088]; figure 1 * ----- | 1,9-15 | TECHNICAL FIELDS SEARCHED (IPC) H03F H04B |
| X | EP 1 703 635 A1 (YAMAHA CORP [JP]) 20 September 2006 (2006-09-20) * paragraph [0034] - paragraph [0036]; figure 1 * ----- | 1,9-11 | |

The present search report has been drawn up for all claims

| Place of search | Date of completion of the search | Examiner |
|---|---|---|
| Munich | 19 September 2013 | Lorenzo, Carlos |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 13 30 5460

This annex lists the patent family members relating to the patent documents cited in the above-mentioned European search report.
The members are as contained in the European Patent Office EDP file on
The European Patent Office is in no way liable for these particulars which are merely given for the purpose of information.

19-09-2013

| Patent document cited in search report | | Publication date | Patent family member(s) | | Publication date |
|---|---|---|---|---|---|
| US 2004212428 | A1 | 28-10-2004 | JP 3857652 B2<br>US 2004212428 A1<br>WO 02087097 A1 | | 13-12-2006<br>28-10-2004<br>31-10-2002 |
| US 2005085199 | A1 | 21-04-2005 | AU 2004222715 A1<br>CA 2484855 A1<br>DE 102004050359 A1<br>GB 2407930 A<br>US 2005085199 A1 | | 24-11-2005<br>16-04-2005<br>16-06-2005<br>11-05-2005<br>21-04-2005 |
| EP 1835626 | A1 | 19-09-2007 | CN 101099296 A<br>EP 1835626 A1<br>JP 4516973 B2<br>US 2007281655 A1<br>WO 2006072973 A1 | | 02-01-2008<br>19-09-2007<br>04-08-2010<br>06-12-2007<br>13-07-2006 |
| EP 1199814 | A1 | 24-04-2002 | DE 69933243 T2<br>EP 1199814 A1<br>JP 4097430 B2<br>US 2002085647 A1<br>WO 0108319 A1 | | 12-04-2007<br>24-04-2002<br>11-06-2008<br>04-07-2002<br>01-02-2001 |
| US 2002097811 | A1 | 25-07-2002 | JP 2002223130 A<br>US 2002097811 A1 | | 09-08-2002<br>25-07-2002 |
| EP 1703635 | A1 | 20-09-2006 | AT 425581 T<br>CN 1835395 A<br>EP 1703635 A1<br>JP 4802765 B2<br>JP 2007135177 A<br>US 2006208794 A1<br>US 2009102557 A1 | | 15-03-2009<br>20-09-2006<br>20-09-2006<br>26-10-2011<br>31-05-2007<br>21-09-2006<br>23-04-2009 |

EPO FORM P0459

For more details about this annex : see Official Journal of the European Patent Office, No. 12/82